# EUROPEAN PATENT APPLICATION

(11) **EP 0 992 609 A1**
(43) Date of publication of application: **12.04.2000**
(21) Application number: 99119302.0
(22) Date of filing: 29.09.1999
(51) Int. Cl.: C23C 16/02, C23C 16/40

(54) **Process for depositing a barrier coating on plastic objects**

(30) Priority: 30.09.1998 US 164538
(71) Applicant: Becton, Dickinson and Company, Franklin Lakes, New Jersey 07417-1880 (US)
(72) Inventor: Dalvie, Manoj, Cupertino, California 95014 (US); Tropsha, Yelena G., Chapel Hill, North Carolinia 27514 (US); Wainwright, Louis P., Durham, North Carolina 27707 (US); Graper, Jane C., Durham, North Carolina 27707 (US)
(74) Representative: von Kreisler, Alek, Dipl.-Chem.

(57) **Abstract**

The present invention is a barrier coating and a method for depositing an inorganic coating on a pre-processed substrate at high power levels. The process of the present invention is useful for providing an effective barrier against gas and/or water permeability of substrates, especially for plastic blood devices. The pre-processed substrate comprises a buffer layer to mechanically isolate the substrate so that the substrate can be subjected to power levels or temperature levels that would typically lead to deformation of the substrate.

## Description

### BACKGROUND OF THE INVENTION

### 1. Field of the Invention

This invention relates to a barrier coating and a method for depositing inorganic films on polymeric substrates by high power plasma enhanced chemical vapor deposition using a mechanical isolation buffer layer.

### 2. Description of the Related Art

In numerous fields of technology, it is necessary to apply very thin coating of pure substances to certain objects. An example is window glass which is provided with a thin coating of metal oxide in order to filter certain wavelength ranges out of sunlight. In semi-conductor technology, thin coatings of one or more substances are often applied to a substrate. It is especially important that the thin coating not only be pure, but also that they be precisely measured out so that the coating thickness and, in the case of chemical compounds, their composition will be accurately repeatable. These coating thickness are typically, between two and several thousand of nanometers.

A variety of methods are know for applying thin coatings to films, glass and other substrates.

Plasma enhanced chemical vapor deposition (PECVD) is a method to deposit coatings on substrates and in particular for plastic substrates. A key variable in PECVD processes is the level of input electrical power (i.e., radio frequency) used to sustain the plasma and bias the substrate. Bias of the substrate is responsible for high energy ion bombardment of the substrate which leads to densification of the coating. Ion bombardment also delivers heat to the substrate surface, which causes a rise in the substrate temperature during the deposition process. If the temperature of the substrate rises above critical value the substrate may deform or soften. Usually this effect takes place in the vicinity of the glass transition temperature, Tg. The glass transition temperature is the temperature of polymer transition from a hard glassy state to a soft rubbery state. Below Tg, the molecular motion is frozen and material turns into glass. When substrate temperatures reach Tg, segment mobility of polymer chains takes place, which creates an unstable deposition platform for inorganic coatings. Therefore, if the substrate is deformed or softened, this could lead to deformation of the coating and cause macroscopic defects. In addition, these defects generally result in a "frosted" appearance of the coating. Since PECVD is easily adaptable to the low substrate temperature requirements of plastic substrates, it is a good method for depositing coatings on plastic substrates. However, low Tg polymers such as polyproplene and PET (Tg is - 10°C and 68°C respectively) can not be exposed to a high system power.

Therefore, a need exists to be able to deposit inorganic coatings to plastic substrates that are free of macroscopic defects at high energy levels with out causing damage to the plastic substrate and consequently defects in the coating.

### SUMMARY OF THE INVENTION

The present invention is a plastic substrate comprising a buffer layer and an inorganic coating and a method for depositing the inorganic coating, substantially free of macroscopic defects on a plastic substrate, at power levels above the threshold at which macroscopic defects normally appear in the coating and with a minimal process time.

Most preferably, the method of the present invention includes a pre-processing step, wherein a buffer layer is applied to the substrate. The buffer layer mechanically isolates the substrate so that the substrate can be subjected to power levels or temperature levels that would typically lead to deformation of the substrate.

Preferably, the buffer layer is substantially free from visable marcoscopic defects whereby it meets clarity requirements of the coating or finished products.

The buffer layer provides a platform for deposition of an inorganic material onto the substrate. Preferably, the thickness of the buffer layer is about 0.1 microns to about 10 microns and most preferably from about 0.5 microns to about 3 microns.

Desirably, the buffer layer is an organic material. Preferably, the buffer layer is clear and free from visible macroscopic defects, substantially hard (because it is a cross-linked polymer), and is able to mechanically isolate the polymer substrate from the PEVCD process. The buffer layer does not soften, undergo glass transition, melt or otherwise deform at a temperature near the Tg of the substrate. Preferably, the buffer layer is a cross linked acrylate material.

Desirably, the inorganic material is a metal oxide, such as a silicon oxide based composition, such as SiOx wherein x is from about 1.0 to about 2.5; or an aluminum oxide based composition.

The silicon oxide based composition is substantially dense and vapor-impervious and is desirably derived from volatile organosilicon compounds. Preferably, the thickness of the silicon oxide based material is about 100 to about 10,000 Angstroms (Å) and most preferably from about 500 to about 3,000 Å. A material above 5,000 Å may crack and therefore be ineffective as a barrier.

The buffer layer may be applied onto the plastic substrate by dipping or spraying and then followed by air drying at about 50°C or UV light.

Most preferably, the method for depositing an inorganic material onto a pre-processed substrate, comprises the following steps:
(a) providing an apparatus capable of applying a barrier film coating to a substrate, said apparatus having: a vacuum tight chamber, means for delivering a monomer to said chamber, a means for applying radio frequency power to said chamber, means for delivering an oxidizer gas to said chamber, a means for creating and maintaining a vacuum inside said chamber; and electrodes;
(b) positioning said substrate in said chamber
(c) evacuating said chamber to below 5m Torr;
(d) delivering a monomer gas to said chamber;
(e) delivering an oxidizer gas to said chamber;
(f) delivering a radio frequency to said electrodes; and
(g) depositing a barrier film coating on said pre-processed substrate.

Preferably, the monomer gas is delivered to the chamber at about 0.1 sccm to about 100 sccm and most preferably at about 20 sccm.

Preferably, the monomer gas is hexamethyldisiloxane (HMDSO) or trimethyldisiloxane (TMSO) and most preferably HMDSO.

Preferably, the oxidizer gas is delivered to the chamber at about 2 sccm to about 2000 sccm and most preferably at about 600 sccm.

Preferably, the oxidizer gas is oxygen, nitrous oxide or air and most preferably oxygen.

Preferably, the radio frequency is from about 5 to about 20 MHz and power per unit of electrode area is from about 0.01 to about 5 watts/cm². Most preferably, the radio frequency is about 10 to about 14 MHz and about 0.1 to about 1 watts/cm².

Preferably, the pre-processed substrate is coated with a barrier film at a rate of about 10 to about 200 nm/min and most preferably at a rate of about 20 to about 100 nm/min.

Plastic substrates that are pre-processed and then coated with a barrier film are able to maintain substantially far better vacuum retention and mechanical integrity retention than previous substrates coated only with a barrrier film. In addition, the substrate's resistance to impact is much better than that of glass. Most notably is the clarity of the SiOx coating with the buffer layer and its durability to substantially withstand resistance to impact and abrasion.

Most preferably, the substrate of the present invention is a blood collection device. The blood collection device can be either an evacuated blood collection tube or a non-evacuated blood collection tube. The blood collection tube is desirably made of polyethylene terephthalate (PET), polypropylene (PP), polyethylene napthalate (PEN), polycarbonate (PC) or copolymers thereof.

In addition to blood collection devices, the process of the of the present invention may be used with polymer films wherein both sides of the film include the buffer layer.

It has been found in the present invention that a highly crosslinked buffer layer of acrylate improves the adhesion between a plastic surface and SiOx and overall improves the thermomechanical stability of the substrate so that it may be subjected to higher power levels without deforming the substrate.

In addition, the acrylate material covers the particles and imperfections on the surface of a polymer. The good bonding properties of the acrylate are also due to the fact that acrylate is polar and the polarity provides means for good bond formation between the SiOx and the acrylate. Thus, the present invention provides the means of substantially improving the barrier properties of polypropylene tubes.

A plastic blood collection tube coated by the method of the present invention will not interfere with testing and analysis that is typically performed on blood in a tube. Such tests include but are not limited to, routine chemical analysis, biological inertness, hematology, blood chemistry, blood typing, toxicology analysis or therapeutic drug monitoring and other clinical tests involving body fluids. Furthermore, a plastic blood collection tube coated by the method of the present invention is capable of being subjected to automated machinery such as centrifuges and may be exposed to certain levels of radiation in the sterilization process with substantially no change in optical or mechanical and functional properties.

Preferably, the method of the present invention provides a coating that is transparent, translucent or colorless appearance and may have printed matter applied thereon.

A notable advantage of the present invention is that inorganic coatings may be applied to a plastic substrate at high energy levels without causing defects to the plastic substrate wherein the inorganic coating is free of macroscopic defects.

A further advantage is that the process of the present invention improves the permeability of three-dimensional objects that would not have been obvious because of the temperature threshold being crossed.

A significant advantage of the process of the present invention is that the buffer layer provides a heat-resistant shield for the threshold temperature for the SiOx application to be increased so that a coating with minimal defects may be applied to a substrate. Therefore, a significant reduction in permeability of the substrates is due to the complete SiOx surface coverage that is obtained.

Notable attributes of the buffer layer include that it is (i) free from visible macroscopic defects; (ii) does not diminish the clarity of the finally coated substrate; and (iii) provides a substantially hard pre-treatment material to the substrate so that the substrate can be subjected to a higher power PEVCD process and consequently high temperature.

Without the buffer layer pre-processing step of the present invention, densification of an inorganic coating or a plastic substrate is limited by the power range over which the substrate retains its structural properties. The pre-processing step of the present invention allows higher power during the PEVCD process because the coating is now buffered from the substrate, thereby enabling coating densities and end properties otherwise not attainable.

Another attribute of the present invention is that the buffer layer delays the onset of frosting of the coating that could occur during a high power PEVCD process.

Another attribute of the present invention is that the the process or duration of time for coating a substrate by PECVD is shortened when a high threshold power is used. Therefore the critical power threshold is inversely related to the duration of the inorganic coating process.

### DESCRIPTION OF THE DRAWINGS

FIG. 1 is a general schematic diagram illustrating an enlarged partially sectioned diagram of a flash evaporator apparatus.
FIG. 2 illustrates the apparatus for plasma enhanced chemical vapor deposition.

### DETAILED DESCRIPTION

The present invention may be embodied in other specific forms, and is not limited to any specific embodiment described in detail which is merely exemplary. Various other modifications will be apparent to and readily made by those skilled in the art without departing from the scope and spirit of the invention. The scope of the invention will be measured by the appended claims and their equivalents.

The plastic substrate used in the process of the present invention may be any substrate which would benefit from reduced gas and/or water vapor transmission in its end use. A representative but not limiting list of such substrates includes films for packaging, containers such as bottles, medical devices such as syringes, tubes, tubing and vials. Most preferably, soft drink containers and medical devices would benefit from reduced gas and/or water vapor transmission.

The preferred embodiment of the present invention is the deposition by plasma enhanced chemical vapor deposition (PECVD) of an inorganic coating onto a pre-processed plastic substrate. The pre-processing step comprises coating the plastic substrate with a buffer layer.

The buffer layer is an organic material such as an acrylate material and may be formed on the plastic substrate by dip-coating, roll-coating or spraying the organic material onto the substrate followed by a UV curing process or drying process.

The organic material may also be applied by an evaporation and curing process carried out as described in U.S. Patent No. 5,032,461, the disclosure of which is herein incorporated by reference.

Acrylates are available with almost any chemistry desired. They usually have either one, two or three acrylate groups per molecule. Various mixtures of mono, di and tri acrylates are useful in the present invention. Most preferable are monoacrylates and diacrylates.

Acrylates form one of the most reactive classes of chemicals. They are cured rapidly when exposed to UV or electron beam radiation to form a cross-linked structure. Therefore acrylates impart high temperature, stability and abrasion resistant properties to compositions and substrates.

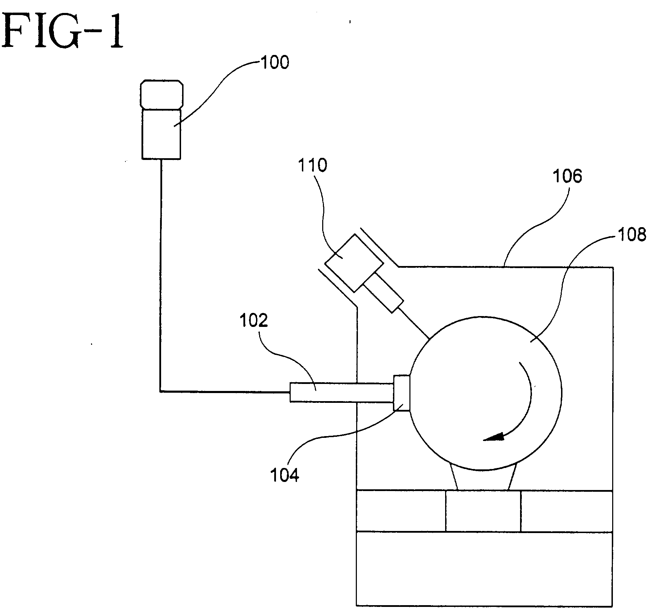

FIG. 1 illustrates one of many processes for applying an acrylate material to a plastic substrate. An acrylate monomer **100** is directed through a dielectric evaporator **102** and then through an ultrasonic atomizer **104** and into a vacuum chamber **106**. The monomer droplets are atomized ultrasonically and the droplets vaporized where they condense on the rotating tube or film that is loaded on a drum **108**.

The condensed monomer liquid subsequently is radiation cured by means of an electron beam gun **110**.

The inorganic material is most preferably an oxide material such as silicon oxide and may be formed by radio frequency discharge, direct or dual ion beam deposition, sputtering or plasma enhanced chemical vapor deposition, as described in U.S. Patent Nos. 4,698,256, 4,809,876, 4,992,298, 5,055,318 and 5,691,007, the disclosures of which are herein incorporated by reference.

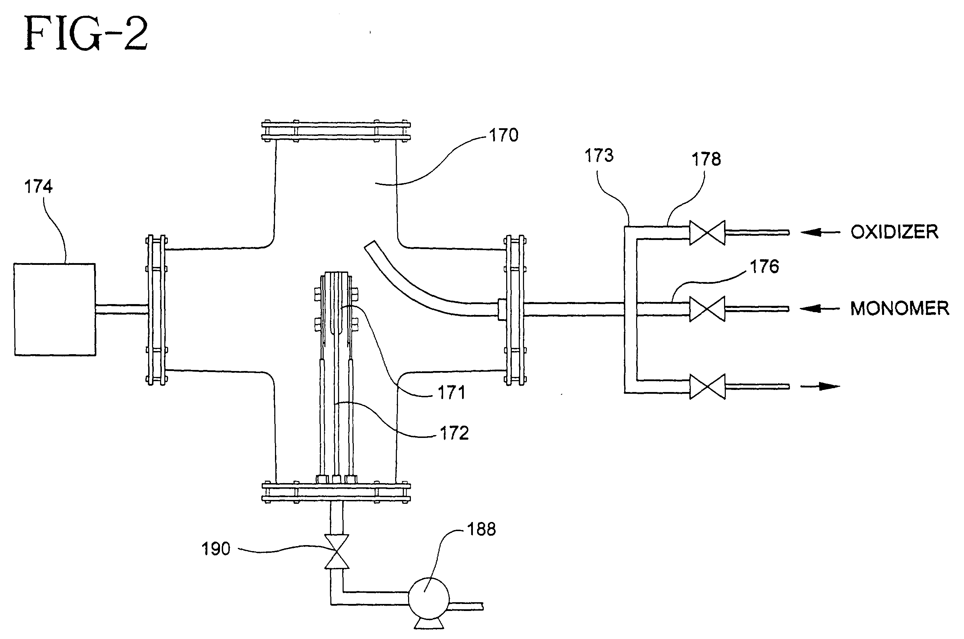

Referring to FIG. 2, the system for depositing a silicon oxide material comprises an enclosed reaction chamber **170** in which a plasma is formed and in which a substrate or tube **171**, is placed for depositing a thin film of material, on a sample holder **172**. The substrate can be any vacuum compatible material, such as plastic. One or more gases are supplied to the reaction chamber by a gas supply system **173**. An electric field is created by a power supply **174**.

The reaction chamber can be of an appropriate type to perform any of the plasma-enhanced chemical vapor deposition (PECVD) or plasma polymerization processes. Furthermore, the reaction chamber may be modified so that one or more substrates may be coated with an oxide layer simultaneously within the chamber.

The pressure of the chamber is controlled by a mechanical pump **188** connected to chamber **170** by a valve **190**.

The substrate to be coated is first loaded into chamber **170** in or on a sample holder **172**. The pressure of the chamber is reduced to about 5 mTorr by mechanical pump **188**. The operating pressure of the chamber is about 50 to about 200 mTorr for a PECVD or plasma polymerization process and is achieved by flowing the process gases, comprising a mixture of an organosilicon vapor (such as HMDSO) for example and an oxidizer (such as oxygen for example) into the chamber through monomer inlet **176** and oxidizer inlet **178**.

An oxide based film is deposited to a desired thickness. The thickness of the oxide material is about 100 Angstroms (Å) to about 10,000 Å. A thickness of less than about 500 Å may not provide sufficient barrier and a thickness of greater than about 5,000 Å may crack, thus decreasing the effective barrier. Most preferably, the thickness of the oxide material is about 500 Å to about 3,000 Å.

The volatilized organosilicon component is preferably admixed with the oxygen component and an inert gas component before being flowed into the chamber. The quantities of these gases being so admixed are controlled by flow controllers so as to adjustably control the flow rate ratio of the gas stream components.

The deposition method of the present invention is preferably practiced at relatively high power and quite low pressure. A pressure less than about 500 millitorr (mTorr) should be maintained during the deposition, and preferably the chamber is at a pressure between about 43 to about 490 millitorr during the deposition of film. Low system pressure results in lower deposition rates whereas higher system pressure provides faster deposition rates.

Examples of suitable organosilicon compounds useful for the gas stream in the plasma deposition method is liquid or gas at about ambient temperature and when volatilized have a boiling point about 0°C to about 150°C and include dimethysilane, trimethylsilane, diethylsilane, propylsilane, phenylsilane, hexamethyldisilane, 1,1,2,2-tetramethyldisilane, bis (trimethylsilane)methane, bis (dimethylsilyl) methane, hexamethyldisiloxane, vinyl trimethoxy silane, vinyl triethyoxysilane, ethylmethoxysilane, ethyltrimethoxysilane, divinyltetramethyldisiloxane, hexamethyldsilazane divinyl-hexamethyltrisiloxane, trivinylpentamethyltrisiloxazane, tetraethoxysilane and tetramethoxysilane.

Among the preferred organosilicons are 1,1,3,3-tetramethyldisiloxane, trimethylsilane, hexamethyldisiloxane, vinyltrimethylsilane, methyltrimethoxysilane, vinyltri methoxysilane and hexamethyldisilazane. These preferred organosilicon compounds have boiling points of 71°C, 55.5°C, 102°C, 123°C and 127°C respectively.

A radio frequency (RF) power generator from power supply **174** is used to generate a plasma with a frequency of about 5 to about 20 MHz and a power per electrode area of about 0.01 to about 5 watts/cm² depending upon the number and proximity of the electrodes. A deposition of SiOₓ thus occurs upon the exposed substrate at a rate of about 22 to about 100 nm/min.

Therefore, as shown in the Examples that follow, a first silicon oxide based film will not completely cover the surface of a substrate when the temperature parameters of the silicon oxide deposition (Tsioₓ) are greater then Tg. When the deposition power exceeds a certain critical value, the polymeric substrate is exposed to a temperature that causes segment mobility of polymeric chains. As a result of this movement, the substrate may soften. Therefore, the substrate may deform or soften thereby causing defect formation of the silicon oxide and macroscopic defects. Therefore, as shown in the Examples that follow complete coverage cannot be achieved with a silicon oxide based film applied at deposition power higher than 130W.

However, a pre-processed substrate with a buffer layer, will completely cover the substrate so that a silicon oxide based film may be applied to the pre-processed substrate by a high power PEVCD process. Therefore, the buffer layer protects the substrate from deforming or softening at temperature parameters greater than Tg or where Tsioₓ>Tg, such that the silicon oxide coating is applied to the substrate free of macroscopic defects at high power levels.

The oxide materials or blends thereof used in accordance with this disclosure, may contain conventional additives and ingredients which do not adversely affect the properties of articles made therefrom.

A variety of substrates can be coated with the process and materials of the present invention. Such substrates include, but are not limited to packaging, containers, bottles, jars, tubes and medical devices.

### EXAMPLE 1

### METHOD FOR APPLYING SIO_{X} ON PLASTIC SUBSTRATES BY HIGH POWER PLASMA ENHANCED CHEMICAL VAPOR DEPOSITION

A buffer layer was applied to PET tubes by dipping the substrate into a blend of RAD-KOTE 110 HS acrylic monomer containing a photo-initiator by Rad-Cure Corporation. The coating was then cured under a F300/F305 Ultraviolet Lamp System.

PET tubes (control) without the buffer layer, and PET tubes with the buffer layer were positioned in a vacuum chamber (as shown in FIG. 2) on electrodes. The chamber was evacuated to about 50 mTorr. Then a monomer, HMDSO, and an oxidizer, oxygen were delivered to the chamber. A power supply was then supplied power to the electrodes and SiOₓ was deposited on the tubes.

The system parameters used for deposition of SiOₓ on the tubes are reported in Table 1.

After the thin film of SiOₓ was deposited, the chamber was allowed to cool. The chamber was then opened, and the tubes were removed. The results are reported in Table 1 and FIG. 3.

The results in Table 1 and FIG. 3 illustrate that PET tubes coated with only SiOₓ begin to frost at a power level beginning at 140 watts, but that PET tubes coated with the buffer layer then with SiOₓ do not frost at a power level of 140 watts and greater.

## Claims

1. A method for depositing an inorganic coating on a plastic substrate at a power level above the threshold of Tg, a comprising the steps of:
(a) dipping or spraying said plastic substrate with a buffer layer material;
(b) drying said buffer layer material;
(c) providing an apparatus capable of applying an inorganic coating to said substrate, said apparatus having: a vacuum tight chamber, means for delivering a monomer to said chamber, means for applying radio frequency power to said chamber, means for delivering an oxidizer gas to said chamber, means for creating and maintaining a vacuum inside said chamber and electrodes;
(d) positioning said substrate in said chamber;
(e) evacuating said chamber to below 5mTorr;
(f) delivering a monomer gas to said chamber;
(g) delivering an oxidizer gas to said chamber;
(h) delivering a radio frequency to said electrodes; and
(i) depositing an inorganic coating on said substrate over said buffer layer material.

2. The method of Claim 1 , wherein said monomer gas is delivered to said chamber at about 0.1 sccm to about 100 sccm.

3. The method of Claim 1, wherein said monomer gas is hexamethyldisiloxane (HMDSO) or trimethyldisiloxane (TMSO).

4. The method of Claim 1, wherein said oxidizer gas is delivered to said chamber at about 2 sccm to about 2000 sccm.

5. The method of Claim 3, wherein said monomer gas is hexamethyldisiloxane.

6. The method of Claim 4, wherein said oxidizer gas is oxygen, nitrous oxide or air.

7. The method of Claim 6, wherein said oxidizer gas is oxygen.

8. The method of Claim 1, wherein said radio frequency is about 5 MH₂ to about 20 MH₂ and about 0.01 watts/cm ² to about 5 watts/cm².

9. The method of Claim 1, wherein said buffer layer material is an organic material.

10. The method of Claim 1, wherein said inorganic coating is silicon oxide or aluminum oxide.
